# EUROPÄISCHE PATENTSCHRIFT

(11) **EP 3 250 892 B1**
(45) Veröffentlichungstag und Bekanntmachung des Hinweises auf die Patenterteilung: **16.10.2019**
(21) Anmeldenummer: 16701632.8
(22) Anmeldetag: 26.01.2016
(51) Int. Cl.: G01D 11/24

(54) **ADAPTER MIT EINGEBETTETEN FILTERBAUELEMENTEN FÜR SENSOREN**
ADAPTER WITH EMBEDDED FILTER COMPONENTS FOR SENSORS
ADAPTATEUR AVEC COMPOSANTS DE FILTRAGE INTÉGRÉS POUR DES CAPTEURS

(30) Priorität: 28.01.2015 DE 102015201480
(43) Veröffentlichungstag der Anmeldung: 06.12.2017
(73) Patentinhaber: Continental Teves AG & Co. OHG, 60488 Frankfurt am Main (DE)
(72) Erfinder: RAUKOPF, Svenja, 35329 Gemünden Felda - Hainbach (DE); SCHILLINGER, Jakob, 85080 Gaimersheim (DE); SCHULMEISTER, Michael, 64846 Groß-Zimmern (DE)
(86) Internationale Anmeldenummer: PCT/EP2016/051571
(87) Internationale Veröffentlichungsnummer: WO 2016/120268

(56) Entgegenhaltungen:
- EP-A1- 2 120 053
- WO-A2-2008/008140
- DE-A1-102005 043 413
- DE-A1-102006 030 081
- DE-A1-102008 064 047
- DE-A1-102014 002 991
- US-A1- 2009 288 484

## Beschreibung

Die Erfindung betrifft einen Sensor zur Erfassung einer physikalischen Größe und eine Steuervorrichtung für ein Fahrzeug mit dem Sensor.

Aus der WO 2010 / 037 810 A1 ist ein Sensor zur Erfassung eines physikalischen Signals bekannt. Der Sensor weist einen Leadframe auf, der als Schaltungssträger die Sensorkomponenten des Sensors trägt und gleichzeitig verschaltet.

Aus DE 10 2006 030081 A1 ist ein Sensor mit einem Stanzgitter und einer Schaltung bekannt, die dazu dient, ein elektrisches Signal mit einem ersten Signalpfad von einem Sensorelement zu empfangen und mit einem zweiten Signalpfad an eine Ausgangsschnittstelle zu leiten.

DE 10 2014 002991 A1 offenbart ein eingebettetes Bauteil, das als Auswerteschaltkreis für einen Sensor mit mehreren Signalpfaden verwendbar ist.

Es ist Aufgabe der Erfindung, den bekannten Sensor zu verbessern. Die Aufgabe wird durch die Merkmale der unabhängigen Ansprüche gelöst. Bevorzugte Weiterbildungen sind Gegenstand der abhängigen Ansprüche.

Das Bauteil für einen Sensor mit einem Sensorelement und einer Ausgangsschnittstelle zum Ausgeben eines von einer physikalischen Größe abhängigen elektrische Signals aus dem Sensorelement an der Ausgangsschnittstelle umfasst eine Schaltung mit wenigstens einem ersten Signalpfad zum Empfangen des elektrischen Signals vom Sensorelement und zum Leiten des elektrischen Signals an die Ausgangsschnittstelle und einen vom ersten Signalpfad verschiedenen zweiten Signalpfad zum Leiten des elektrischen Signals an die Ausgangsschnittstelle, wobei eine Aktivität des ersten Signalpfades oder des zweiten Signalpfades von einer Lage des Bauteils in dem Sensor abhängig ist.

Dem angegebenen Bauteil liegt die Überlegung zugrunde, dass ein Sensor in der Regel in einer applikationsabhängigen Anwendungsumgebung zum Einsatz kommt. So ist es möglich, dass unterschiedliche Steuergeräte in einem Fahrzeug, in denen der Sensor grundsätzlich verwendet werden kann, das Signal an unterschiedlichen Pins des Sensors abgreifen. Zwar kann auf diese Weise das Sensorelement selbst standardisiert und kostengünstig gefertigt werden, der Sensor selbst ist jedoch wieder applikations- und damit kundenspezifisch herzustellen, was die Herstellungskosten in die Höhe treibt.

Hier greift das angegebene Bauteil mit dem Vorschlag an, die aus dem Sensorelement ausgegebenen Signale zu routen. Hierfür weist das angegebene Bauteil die verschiedenen Signalpfade auf. Je nachdem, welcher Signalpfad aktiv ist, kann ein entsprechender Pin an einer dem Sensor der übergeordneten Anwendung mit dem elektrischen Signal aus dem Sensorelement versorgt werden. Durch einfaches Versetzen des angegebenen Bauteils in dem Sensor lassen sich so die verschiedenen anwendungsabhängigen Konfigurationen einstellen, wobei sowohl das Sensorelement als auch das Bauteil selbst kostengünstig in einer standardisierten Form gefertigt werden kann.

Die Ausgangsschnittstelle des angegebenen Bauteils umfasst daher in einer bevorzugten Ausgestaltung verschiedene Ausgangspins, wobei die beiden Signalpfade eingerichtet sind, das elektrische Signal zu verschiedenen Ausgangspins zu leiten.

In einer alternativen oder zusätzlichen Ausgestaltung des zuvor erläuterten Gedankens können die verschiedenen Signalpfade auch dazu genutzt werden, um vor der Ausgabe des elektrischen Signals an die Ausgangsschnittstelle verschiedene, anwendungsabhängige Funktionen zu realisieren. Hierzu in dem Bauteil wenigstens ein elektrisches Bauelement vorhanden sein, über das der erste und/oder der zweite Signalpfad geführt ist.

Das elektrische Bauelement kann beispielsweise eingerichtet sein, Störanteile aus dem elektrischen Signal zu filtern. Auf diese Weise wird die elektromagnetische Verträglichkeit eines Sensors mit dem angegebenen Bauteil gesteigert.

In einer zusätzlichen Weiterbildung des Bauteils kann die Schaltung in einer Einbettmasse verkapselt sein. Durch das Verkapseln des Bauteils werden die Signalpfade und gegebenenfalls die elektrischen Bauelemente geschützt. Das Bauteil kann dann zur Positionierung im Sensor problemlos berührt werden. Zusätzlich kann mechanischer Stress auf die Bauteile reduziert werden, weil die Bauteile in der Einbettmasse an Symmetriestellen positionierbar sind, die sogenannte neutrale Fasen darstellen, an denen der mechanische Stresseintrag gering ist.

Um einen möglichst hohen Schutz der elektrischen Kompenten des angegebenen Bauteils zu erreichen, sollte das angegebene Bauteil Pinflächen umfassen, über die die Signalpfade aus der Einbettmasse zur Kontaktierung an das Sensorelement und an die Ausgangsschnittstelle nach außen hin exponiert sind. Alle anderen elektrischen Komponenten des angegebenen Bauteils können so von der Einbettmasse geschützt werden.

In einer anderen Weiterbildung des angegebenen Bauteils kann die Einbettmasse ein Harz sein.

Gemäß der Erfindung umfasst ein Sensor zum Erfassen einer physikalischen Größe ein Sensorelement zum Erfassen und Ausgeben eines von der physikalischen Größe abhängigen elektrischen Signals, ein das Sensorelement tragendes Substrat mit einer Leiterbahn, eine Ausgangsschnittstelle zum Ausgeben des elektrischen Signals an eine übergeordnete Einrichtung, und eines der angegebenen Bauteile zum Leiten des elektrischen Signals von der Leiterbahn des Substrats an die Ausgangsschnittstelle.

Gemäß einem weiteren Aspekt der Erfindung umfasst eine Steuervorrichtung für ein Fahrzeug zum Steuern eines Verhaltens des Fahrzeuges basierend auf einer erfassten physikalischen Größe einen angegebenen Sensor zum Erfassen der physikalischen Größe.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 eine schematische Ansicht eines Fahrzeuges mit einer Fahrdynamikregelung,
Fig. 2 eine Prinzipdarstellung eines Drehzahlsensors in dem Fahrzeug der Fig. 1,
Fig. 3 einen schematische Darstellung eines Lesekopfes des Drehzahlsensors der Fig. 2 in einem Zwischenproduktionszustand
Fig. 4 eine schematische Schnittansicht eines alternativen Lesekopfes,
Fig. 5 eine schematische Draufsicht auf den alternativen Lesekopf aus Fig. 4,
Fig. 6 eine schematische Schnittansicht eines Bauteils aus dem alternativen Lesekopf, und
Fig. 7 eine schematische Ansicht einer idealen, theoretischen Anordnung verschiedener Bauelemente für das Bauteil aus Fig. 6 zeigen.

In den Figuren werden gleiche technische Elemente mit gleichen Bezugszeichen versehen und nur einmal beschrieben.

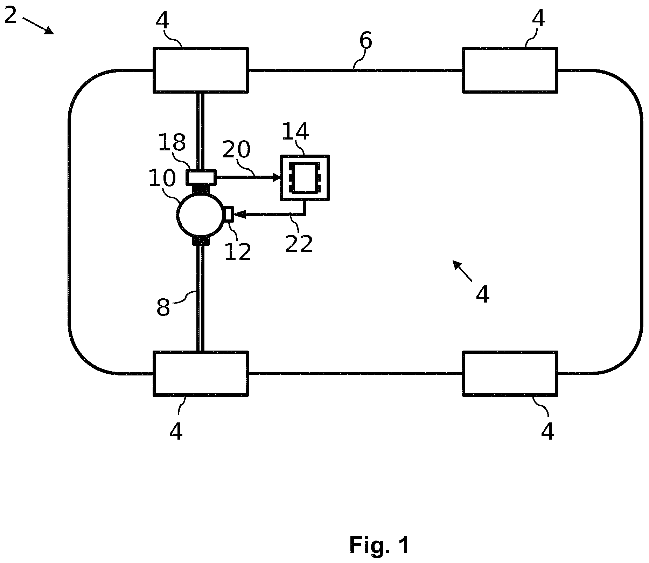

Es wird auf Fig. 1 Bezug genommen, die schematisch ein Fahrzeug 2 mit einem auf Rädern 4 getragenen Chassis 6 zeigt. Zwei der Räder 4 werden dabei über eine Achse 8 von einem Verbrennungsmotor 10 angetrieben. Die grundlegende Funktionsweise eines Verbrennungsmotors ist an sich bekannt und soll daher nachstehend nicht weiter thematisiert werden.

In an sich bekannter Weise, siehe beispielsweise DE 10 2012 206 552 A1 können die Ventilsteuerzeiten des Verbrennungsmotors 10 mit einem Nockenwellenversteller 12 eingestellt werden, um für eine bessere Treibstoffausnutzung in verschiedenen Drehzahlbereichen den Lastpunkt des Verbrennungsmotors 10 zu beeinflussen. Hierzu erfasst eine Nockenwellenansteuereinrichtung 14 über einen Drehzahlsensor 18 die Drehzahl 20 des Verbrennungsmotors 10 und steuert mit einem Steuersignal 22 den Nockenwellenversteller 12 basierend auf der erfassten Drehzahl 20 an. Die Erzeugung des Steuersignals 18 basierend auf der Drehzahl 20 ist an sich bekannt und soll nachstehend nicht weiter erläutert werden. Details hierzu finden sich in der einschlägigen Fachliteratur.

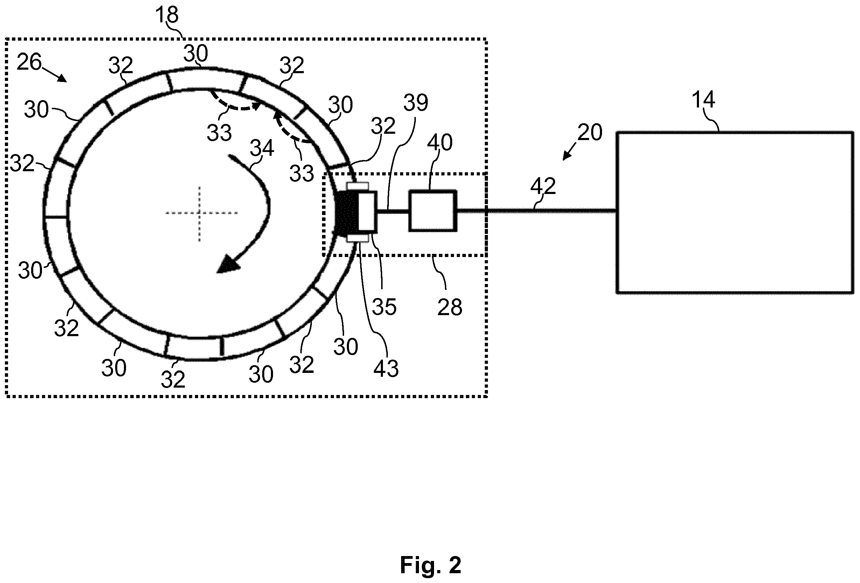

Der Drehzahlsensor 18 ist im Rahmen der vorliegenden Ausführung in einer besonderen Weise ausgebildet. Bevor hierrauf näher eingegangen wird, soll der grundsätzliche Aufbau des Drehzahlsensors 18 selbst näher erläutert werden. Hierzu wird auf Fig. 2 Bezug genommen, die eine schematische Ansicht einer möglichen Ausführung des Drehzahlsensors 18 in dem Fahrzeug 2 der Fig. 1 zeigt.

Der Drehzahlsensor 18 ist in der vorliegenden Ausführung als aktiver Drehzahlsensor ausgeführt, der eine drehfest am nicht gezeigten Rotor des Verbrennungsmotors 10 befestigte Encodersscheibe 26 und einen ortsfest zum Chassis 6 befestigen Lesekopf 28 umfasst.

Die Encoderscheibe 26 besteht in der vorliegenden Ausführung aus aneinandergereihten Magnetnordpolen 30 und Magnetsüdpolen 32, die gemeinsam ein mit einem beispielhaften Pfeil angedeutetes magnetisches Encoderfeld 33 erregen. Dreht sich die am Rotor des Verbrennungsmotors 10 befestigte Encoderscheibe 26 mit diesem in eine Drehrichtung 34, so dreht sich das magnetische Encoderfeld 33 mit.

Der Lesekopf 28 umfasst in der vorliegenden Ausführung einen Messfühler 35, der in Abhängigkeit der Bewegung des magnetischen Encoderfeldes 17 ein elektrisches Gebersignal 39 erzeugt. Hierzu kann jedes beliebige Messprinzip herangezogen werden, wie beispielsweise ein Messprinzip basierend auf dem magnetoresistiven Effekt. Das elektrische Gebersignal 39 ist damit von der zu erfassenden Drehzahl 20 abhängig.

Das Gebersignal 39 kann dann in einer im Lesekopf 28 angeordneten Signalverarbeitungsschaltung 40 aufbereitet werden. In der Regel wird hier aus dem Gebersignal 39 ein Pulssignal 42 erzeugt, wobei das Pulssignal 42 über einen vorbestimmten Zeitabschnitt eine Anzahl von Pulsen umfasst, die von der zu erfassenden Drehzahl abhängig ist. Dieses Pulssignal 42 wird dann an die Nockenwellensteuereinrichtung 14 ausgegeben, die dann die Drehzahl 20 durch Zählen der Pulse in dem Pulssignal 42 ableiten kann.

Weil durch den Verbrennungsmotor 10 in an sich bekannter Weise nicht unbeachtliche Störfelder auftreten, ist in dem Lesekopf 28 ein Stützmagnet 43 angeordnet, der diesen Störfeldern entgegenwirkt und so eine Erfassung der Drehzahl 20 mit niedrigen Toleranzen ermöglicht. Der Stützmagnet 43 sollte daher entsprechend stark gewählt werden, um den Störfeldern ausreichend entgegenwirken zu können.

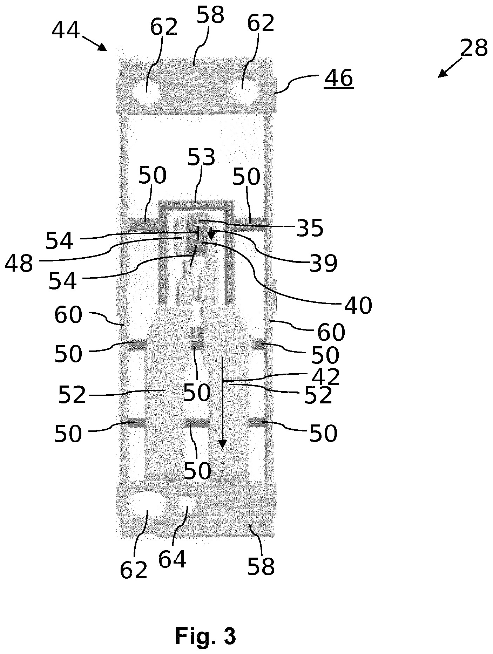

Herkömmlich wird der Lesekopf 28 auf einem Leadframe ausgeführt, wie er beispielsweise aus dem eingangs genannten Stand der Technik WO 2010 / 037 810 A1 bekannt ist. Ein derartiger Leadframe ist beispielsweise in Fig. 3 gezeigt und mit dem Bezugszeichen 44 referenziert. Der Leadframe 44 umfasst einen Halterahmen 46, eine Bestückinsel 48, auf der der Lesekopf 28 gehalten und verschaltet ist, zwei Dambars 50 und zwei Kontaktanschlüsse 52. Dabei halten die Dambars 50 die Kontaktanschlüsse 52 direkt und die Bestückinsel 48 über einen Hilfsrahmen 53 am Halterahmen 46. In dem Leadframe 44 sind der Halterahmen 46, die Bestückinsel 48, die Dambars 50, die Kontaktanschlüsse 52 und der Hilfsrahmen 53 als einstückiges Stanzteil oder Stanzrahmen ausgebildet, in dem die zuvor genannten Elemente durch Stanzen aus einem elektrisch leitfähigen Blech geformt werden.

Auf der Bestückinsel 48 wird im Rahmen der vorliegenden Ausführung der Messfühler 35, beispielsweise in Form eines magnetoresistiven Elements und die Signalauswerteschaltung 40 aufgebracht und elektrisch beispielsweise durch Löten oder Verkleben kontaktiert. Der Messfühler 35 und die Signalauswerteschaltung 40 sind dabei ferner über einen Bonddraht 54 miteinander verbunden, so dass über die Bestückinsel 48 und den Bonddraht 54 zwischen Messfühler 35 und der Signalauswerteschaltung 40 das Probesignal 39 übertragen werden kann.

Die Bestückinsel 48 ist in der vorliegenden Ausführung direkt mit einem der beiden Kontaktanschlüsse 52 verbunden, während der andere der beiden Kontaktanschlüsse 52 von der Bestückinsel 48 galvanisch getrennt und mit der Signalauswerteschaltung 40 über einen weiteren Bonddraht 54 verbunden ist. Auf diese Weise kann über die beiden Kontaktanschlüsse 56 das Datensignal 42 aus der Signalauswerteschaltung 40 ausgegeben werden.

Der Halterahmen 46 weist im Rahmen der vorliegenden Ausführung zwei parallel zueinander verlaufende Transportsteifen 58 auf, die über Verbindungsstege 60 miteinander verbunden sind. Auf dem Transportstreifen 58 sind dabei Transportlöcher 62 ausgebildet, in die ein nicht weiter dargestelltes Transportwerkzeug eingreifen und den Leadframe 44 bewegen kann. Ferner ist auf dem Transportstreifen 58 ein Indexloch 64 ausgebildet, mittels dem die Lage des Leadframes 44 beim Transport bestimmt und damit geregelt werden kann.

Zum Schutz des Lesekopfes 28 kann um die den Lesekopf 28 tragende Bestückinsel 48 und einen Teil der Kontaktanschlüsse 52 ein Gehäuse ausgebildet werden. Das Gehäuse kann beispielsweise als Schutzmasse um den Lesekopf 28 ausgebildet werden, wozu der Kürze halber auf den einschlägigen Stand der Technik, wie beispielsweise die DE 10 2008 064 047 A1 verwiesen wird.

Dieser Lesekopf 28 überträgt in der Regel jedoch an die Nockenwellenansteuereinrichtung 14 nicht nur das Pulssignal 42 sondern auch andere Signale, die beispielsweise zur Fehlererkennung verwendet werden können. Zudem sind in Sensoren, wie dem beschriebenen Drehzahlsensor 18 auch Maßnahmen notwendig, die die elektromagnetische Verträglichkeit, EMV genannt erhöhen.

Abhängig von der Art des das Pulssignal 42 empfangenden Steuergerätes, wie die Nockenwellenansteuereinrichtung 14 oder aber auch abhängig von dessen Hersteller muss das Pulssignal 42 an einem anderen Kontaktanschluss 52 ausgegeben werden.

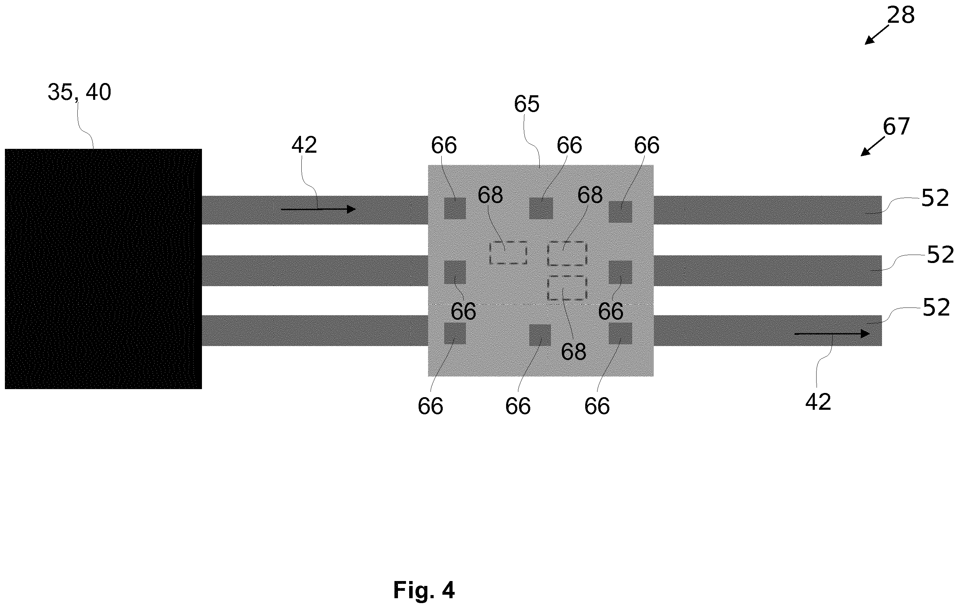

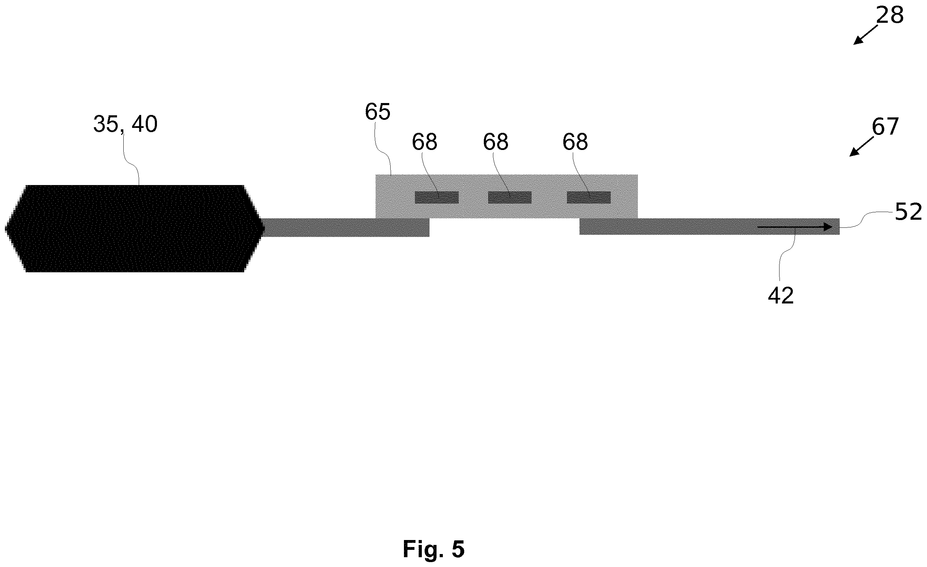

Hier greift das Ausführungsbeispiel mit dem Vorschlag an, ein in Fig. 4 und 5 dargestelltes Bauteil 65 als Adapter zu verwenden und die einzelnen Signale aus dem Lesekopf 28 entsprechend in den Kontaktanschlüssen 52 umzuverdrahten. Hierzu weist das Bauteil 65 mehrere Pinflächen 66 auf. Jede Pinfläche 66 kann sowohl ein Signal vom Messfühler 35 beziehungsweise der Signalverarbeitungsschaltung 40 empfangen, als auch ein Signal an eine Ausgangsschnittstelle 67 ausgeben. Die einzelnen Pinflächen 66 können über nicht weiter dargestellte Signalpfade miteinander verdrahtet sein.

Das Bauteil 65 kann mehr Pinflächen 66 aufweisen, als zum Routen der Signale, wie dem Pulssignal 42 abschließend notwendig ist. Auf diese Weise kann durch eine einfache Lageänderung des Bauteils 65 (in Fig. 4 beispielsweise durch Drehung) ein anderes Verdrahtungsverhalten der Signale in dem Lesekopf 28 herbeigeführt werden.

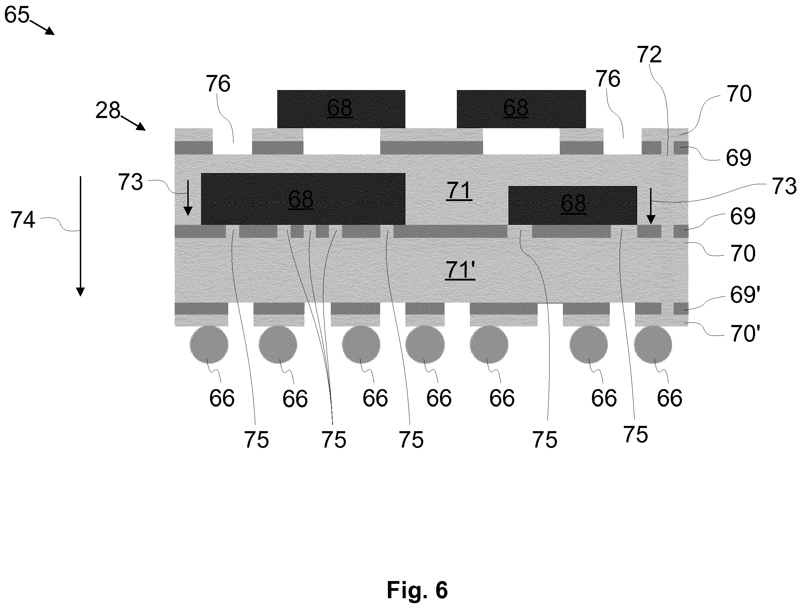

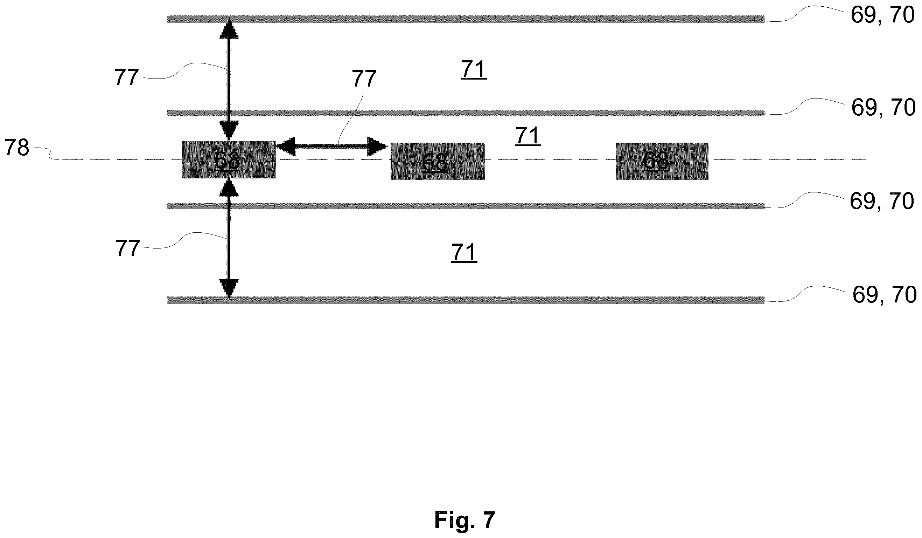

Ferner können in dem Bauteil 65 zusätzliche Bauelemente 68, wie Filterbauelemente verschaltet werden, um aus den Signalen, wie dem Pulssignal 42 die oben genannten Störanteile herauszufiltern und so die EMV zu steigern. Diese Bauelemente 68 können in dem Bauteil 65 in der nachstehenden Weise eingebettet werden, was anhand der Fig. 6 und 7 näher erläutert werden soll.

Das Bauteil 65 kann als Leiterplattenmodul ausgeführt werden und mehrere übereinander gestapelte Isolierschichten 69 umfassen, auf denen Leiterbahnen 70 aufgetragen sind. Auf den Leiterbahnen 70 oder auf den Isolierschichten 69 sind die zuvor genannten Bauelemente 68 des Bauteils 65 getragen, die die elektromagnetische Verträglichkeit des Lesekopfes 28 und damit des Drehzahlsensors 18 steigern sollen. Die Leiterbahnen 70 selbst können Teil der zuvor genannten Signalpfade sein oder diese vollständig realisieren.

Einige der Bauteile 68 sind in der vorliegenden Ausführung zwischen zwei Isolierschichten 69 des als Leiterplattenmodul ausgeführten Bauteils 65 in einer Einbettmasse 71 eingebettet. Auf diese Weise sind diese Bauteile 68 vor äußeren Einflüssen geschützt. Die einzelnen Schichten können elektrisch über Kontaktierungsbohrungen 72 miteinander verbunden werden. Ferner können an dem Bauteil 65 Lötstellen vorhanden sein, die die oben genannten Pinflächen 66 realisieren.

Die Einbettung gemäß Fig. 6 sollte dabei in besonderer Weise erfolgen. Individueller mechanischer Stress 73, der durch die einzelnen mechanischen Bauelemente 68 beispielsweise durch Temperaturbewegungen hervorgerufen wird und sich zu einem mechanischen Gesamtstress 74 summiert kann das Bauteil 65 verformen. Durch diese Verformung können sich unter anderem die Lötstellen 72 von der übergeordneten Schaltung lösen, und zu einem Ausfall des Lesekopfes 28 und damit Drehzahlsensors 18 führen.

Daher sollte das Bauteil 65 möglichst symmetrisch ausgeführt werden, damit sich der durch die einzelnen Bauelemente 68 hervorgerufene individuelle mechanische Stress 73 gegenseitig auslöscht und so den mechanischen Gesamtstress 74 minimiert. Hierzu sind in dem Bauteil 65 verschiedene Ausgleichselemente vorhanden, die einem individuellen mechanischen Stress 73 entgegenwirken können. Es ist nicht zwingend notwendig alle gezeigten Ausgleichselemente in dem Bauteil 65 tatsächlich zu realisieren, um den Gedanken hinter der Ausführung umzusetzen. Die einzelnen gezeigten Ausgleichselemente sollen lediglich beispielhaft verdeutlichen, wie die Bauelemente 68 in dem Bauteil 65 symmetrisch angeordnet werden können, um den mechanischen Gesamtstress 74 unterhalb einer bestimmten, vertretbaren Grenze zu halten.

Zum einen ist es möglich, als Ausgleichselement eine redundate Leiterbahn 70' und eine redundante Isolierschicht 69' einzuführen, um die Leiterbahnanordnung in dem Leiterplattenmodul 66 symmetrisch auszubilden. Folglich wird hierbei auch eine redundante Einbettmasse 71' eingebracht, die sich von der Einbettmasse 71 unterscheiden kann oder aber auch gleich zu dieser gewählt werden kann.

Als weitere Möglichkeit können einzelne der Bauelemente 68 zueinander symmetrisch angeordnet sein. Vorteil hierbei ist es, dass als Ausgleichselemente keine redundanten Elemente in das Bauteil 65 eingebracht werden müssen. Um Unterschiede in der geometrischen, materiellen oder anderweitigen Beschaffenheit zwischen den beiden eingebetteten Bauelementen 68 auszugleichen, ist es weiterhin möglich, die Kontaktierungen 75 der Leiterbahnen 70 zu den einzelnen eingebetteten Bauelementen 68 unterschiedlich geometrisch zu dimensionieren, was in Fig. 6 durch unterschiedlich breite Kontaktierungen 75 an den beiden eingebetteten Bauelementen 68 angedeutet ist.

Zudem können redundante Ausnehmungen 76 als Ausgleichselemente in das Leiterplattenmodul 66 eingebracht werden.

Der Idealfall des Bauteils 65 ist in Fig. 7 dargestellt. Hier sind alle Abstände 77 zwischen den einzelnen Bauelementen 68 untereinander symmetrisch zu einer Symmetrieachse 78 ausgeführt. Praktisch ist dieses ideale Konzept jedoch schon allein deshalb nicht umzusetzen, weil die Bauelemente 68 dann nicht mehr mit den Leiterbahnen 70 kontaktiert werden könnten. Jedoch sollte der Idealfall bei der Konstruktion des Bauteils 65 versucht werden, so gut wie möglich zu erreichen.

Durch das Einbetten der Bauelemente 68 in dem Bauteil 65 ist es möglich, eine deutliche Miniaturisierung zu erreichen. Ferner ist es nicht notwendig, die einzelnen Bauelemente 68 noch einmal in einem extra Verkapselungsschritt, beispielsweise durch Spritzpressen bei mit der oben im Rahmen der Fig. 3 genannten Schutzmasse zu umhüllen. Durch das vollflächige Umschließen der Bauelemente mit der Einbettmasse 71, beispielsweise in Form eines Harzes ist eine derartige Schutzmasse obsolet. Ein Harz bietet zugleich bessere thermische Eigenschaften zur Ableitung von Wärme erzeugt durch Verlustleistung der Komponenten als z. B. Luftkonvektion.

## Patentansprüche

1. Sensor (28) zum Erfassen einer physikalischen Größe (20), umfassend:
- ein Sensorelement (35) zum Erfassen eines von der physikalischen Größe (20) abhängigen elektrischen Signals (42),
- ein das Sensorelement (35) tragendes Substrat (48) mit einer Leiterbahn,
- eine Ausgangsschnittstelle (67) zum Ausgeben des elektrischen Signals (42) an eine übergeordnete Einrichtung (14), und
- ein Bauteil (65), zum Leiten des elektrischen Signals (42) von der Leiterbahn des Substrats (48) an die Ausgangsschnittstelle (67), umfassend:
- eine Schaltung mit wenigstens einem ersten Signalpfad (70) zum Empfangen des elektrischen Signals (42) vom Sensorelement (35) und zum Leiten des elektrischen Signals (42) an die Ausgangsschnittstelle (67) und einen vom ersten Signalpfad (70) verschiedenen zweiten Signalpfad (70) zum Empfangen des elektrischen Signals (42) vom Sensorelement (35) und zum Leiten des elektrischen Signals (42) an die Ausgangsschnittstelle (67),
- wobei abhängig von einer Lage des Bauteils (65) in dem Sensor (28) der erste Signalpfad (70) oder der zweite Signalpfad (70) das Sensorelement (35) elektrisch mit der Ausgangsschnittstelle (67) kontaktiert, wobei die Schaltung in einer Einbettmasse (71) verkapselt ist,
- Pinflächen (66), über die die Signalpfade (70) aus der Einbettmasse (71) zur Kontaktierung an das Sensorelement (35) und an die Ausgangsschnittstelle (67) nach außen hin exponiert sind.

2. Sensor (28) nach Anspruch 1, wobei die Ausgangsschnittstelle (67) verschiedene Ausgangspins (52) umfasst, und die beiden Signalpfade (70) eingerichtet sind, das elektrische Signal (42) zu verschiedenen Ausgangspins (52) zu leiten.

3. Sensor (28) nach Anspruch 1 oder 2, wobei das Bauteil (65) wenigstens ein elektrisches Bauelement (68) umfasst, über das der erste und/oder der zweite Signalpfad (70) geführt ist/sind.

4. Sensor (28) nach Anspruch 3, wobei das elektrische Bauelement (68) eingerichtet ist, Störanteile aus dem elektrischen Signal (42) zu filtern.

5. Sensor (28) nach einem der vorhergehenden Ansprüche, wobei die Einbettmasse (70) ein Harz ist.

6. Steuervorrichtung für ein Fahrzeug (2) zum Steuern eines Verhaltens des Fahrzeuges (2) basierend auf einer erfassten physikalischen Größe (20), umfassend einen Sensor (28) nach einem der vorhergehenden Ansprüche zum Erfassen der physikalischen Größe (20).

## Claims

1. Sensor (28) for detecting a physical variable (20), comprising:
- a sensor element (35) for detecting an electrical signal (42) that is dependent on the physical variable (20),
- a substrate (48) having a conductor track and carrying the sensor element (35),
- an output interface (67) for outputting the electrical signal (42) to a superordinate device (14), and
- a component (65) for leading the electrical signal (42) from the conductor track of the substrate (48) to the output interface (67), comprising:
- a circuit having at least one first signal path (70) for receiving the electrical signal (42) from the sensor element (35) and for leading the electrical signal (42) to the output interface (67) and a second signal path (70), different from the first signal path (70), for receiving the electrical signal (42) from the sensor element (35) and for leading the electrical signal (42) to the output interface (67),
- wherein, depending on a position of the component (65) in the sensor (28), the first signal path (70) or the second signal path (70) electrically contact-connects the sensor element (35) to the output interface (67), wherein the circuit is encapsulated in an embedding compound (71),
- pin areas (66) via which the signal paths (70) are exposed to the outside from the embedding compound (71) in order to make contact with the sensor element (35) and the output interface (67).

2. Sensor (28) according to Claim 1, wherein the output interface (67) comprises various output pins (52), and the two signal paths (70) are configured to lead the electrical signal (42) to various output pins (52).

3. Sensor (28) according to Claim 1 or 2, wherein the component (65) comprises at least one electric component (68) via which the first and/or the second signal path (70) is/are led.

4. Sensor (28) according to Claim 3, wherein the electric component (68) is configured to filter interfering components out of the electrical signal (42).

5. Sensor (28) according to one of the preceding claims, wherein the embedding compound (70) is a resin.

6. Control apparatus for a vehicle (2) for controlling a behaviour of the vehicle (2) based on a detected physical variable (20), comprising a sensor (28) according to one of the preceding claims for detecting the physical variable (20).

## Revendications

1. Capteur (28) destiné à détecter une grandeur physique (20), ledit capteur comprenant :
- un élément capteur (35) destiné à détecter un signal électrique (42) en fonction de la grandeur physique (20),
- un substrat (48) portant l'élément capteur (35) et pourvu d'une piste conductrice,
- une interface de sortie (67) destinée à délivrer le signal électrique (42) à un dispositif d'ordre supérieur (14), et
- un composant (65) destiné à conduire le signal électrique (42) de la piste conductrice du substrat (48) vers l'interface de sortie (67), comprenant :
- un circuit comportant au moins un premier chemin de signal (70) destiné à recevoir le signal électrique (42) de l'élément capteur (35) et à conduire le signal électrique (42) vers l'interface de sortie (67) et un deuxième chemin de signal (70), différent du premier chemin de signal (70), destiné à recevoir le signal électrique (42) depuis l'élément capteur (35) et à conduire le signal électrique (42) vers l'interface de sortie (67),
le premier chemin de signal (70) ou le deuxième chemin de signal (70) étant en contact électrique avec l'élément de capteur (35) et l'interface de sortie (67) en fonction de la position du composant (65) dans le capteur (28), le circuit étant encapsulé dans une matière d'enrobage (71),
- des surfaces de broche (66) par le biais desquelles les chemins de signal (70) sont exposés à l'extérieur depuis la matière d'enrobage (71) pour venir en contact avec l'élément capteur (35) et l'interface de sortie (67) .

2. Capteur (28) selon la revendication 1, l'interface de sortie (67) comprenant différentes broches de sortie (52), et les deux chemins de signal (70) étant conçus pour conduire le signal électrique (42) vers des broches de sortie différentes (52).

3. Capteur (28) selon la revendication 1 ou 2, le composant (65) comprenant au moins un composant électrique (68) par le biais duquel le premier et/ou le deuxième chemin de signal (70) est/sont guidé(s).

4. Capteur (28) selon la revendication 3, le composant électrique (68) étant conçu pour filtrer les composantes parasites du signal électrique (42).

5. Capteur (28) selon l'une des revendications précédentes, la matière d'enrobage (70) étant une résine.

6. Dispositif de commande d'un véhicule (2), ledit dispositif étant destiné à commander le comportement du véhicule (2) sur la base d'une grandeur physique (20) détectée, ledit dispositif comprenant un capteur (28) selon l'une des revendications précédentes destiné à détecter la grandeur physique (20).
